# EUROPEAN PATENT APPLICATION

(11) **EP 3 637 965 A1**
(43) Date of publication of application: **15.04.2020**
(21) Application number: 18802649.6
(22) Date of filing: 02.05.2018
(51) Int. Cl.: H05K 3/22, H01L 23/12

(54) **BOARD FOR MOUNTING ELECTRONIC COMPONENT, AND MANUFACTURING METHOD THEREFOR**

(30) Priority: 19.05.2017 JP 2017099582; 17.11.2017 JP 2017221812
(71) Applicant: Sasaki, Beji, Tokyo 101-0042 (JP)
(72) Inventor: Sasaki, Beji, Tokyo 101-0042 (JP)
(74) Representative: AWA Sweden AB
(86) International application number: PCT/JP2018/017503
(87) International publication number: WO 2018/211992

(57) **Abstract**

A substrate has an insulating layer 11; an adhesion layer 200 provided on the insulating layer 11; and a metal layer 220 provided on the adhesion layer 200. The adhesion layer 200 has an adhesion main body layer 210 and an anchor body 215 protruded from a front surface of the adhesion main body layer 210 or has a redox layer 250.

## Description

### Technical Field

The present disclosure relates to an electronic component mounting substrate and a method of manufacturing the same.

### Background Art

In association with high density mounting of electronic apparatus, higher density, miniaturization, thinning, and multilayering of conductors are required for an electronic component mounting substrate. When conductors are densely mounted or miniaturized, if adhesiveness between an insulating layer and the conductors formed on the insulating layer is not sufficient, adhesion between the insulating layer and the conductors is insufficient. When the conductors are multilayered in the insulating layer, adhesion between the insulating layer and the conductors is insufficient.

When using a semi-additive method to form a conductor, a technique that improves adhesiveness between the insulating layer and the conductor by heating the insulating layer is proposed (e.g., refer to Patent Literature 1).

### Citation List

### Patent Literature

Patent Literature 1: JP 2012-169600 A

### Summary of Invention

### Technical Problem

However, when trying to make a thin printed circuit board or trying to cause a surface of the insulating layer and a conductor to adhere to each other by the semi-additive method or the like, it is not possible to sufficiently secure the adhesiveness between the insulating layer and the conductor. Alternatively, when the insulating layer is thin, peeling of the conductor often easily occurs. When the adhesiveness between the insulating layer and the conductor is insufficient, there is a problem that the printed circuit board cannot be manufactured in the first place or even when the printed circuit board can be manufactured, deterioration of manufacturing yield is unavoidable.

Therefore, to solve the above problem, an object of the present disclosure is to improve adhesiveness of the electronic component mounting substrate.

### Solution to Problem

To achieve the above object, an adhesion layer to improve adhesion strength between the insulating layer and the conductor is formed between the insulating layer and the conductor. When one or more of combination layers of an insulating layer and a conductor are formed on an insulating layer, an adhesion layer to increase adhesion strength between an insulating layer and a conductor included in at least any one of the combination layers is formed between the insulating layer and the conductor.

The electronic component mounting substrate described in the present disclosure is a substrate on which an electronic component can be mounted and where a conductor may be formed on an insulating layer. In the present disclosure, a substrate where a conductor is formed on an insulating layer is called the electronic component mounting substrate. Further, the present disclosure includes an electronic component, an electronic device, and a mounting apparatus, where the electronic component mounting substrate according to the present disclosure is mounted. For example, the mounting apparatus according to the present disclosure is an arbitrary apparatus including the electronic component mounting substrate according to the present disclosure and an electronic component that performs predetermined processing by using the electronic component mounting substrate. In this way, the present disclosure can be applied to various electronic components, electronic devices, and apparatuses, which operate using the electronic component mounting substrate.

### Advantageous Effects of Invention

According to the present disclosure, an adhesion layer is provided on an insulating layer or between an insulating layer and a conductor, so that it is possible to improve adhesiveness, that is, peel strength of the electronic component mounting substrate. Thereby, the present disclosure can prevent deterioration of yield rate when manufacturing the electronic component mounting substrate, improve durability of the electronic component mounting substrate, and comprehensively improve quality of the electronic component mounting substrate. Further, the present disclosure can improve reliability of an electronic component, an electronic device, and an apparatus, which operate using a wiring substrate of the present disclosure.

### Brief Description of Drawings

Fig. 1 is a diagram illustrating an adhesion layer forming process and a conductor forming process.
Fig. 2 is a diagram illustrating a heating process.
Fig. 3 is a diagram illustrating a pushing process.
Fig. 4 is a diagram illustrating a heating procedure.
Fig. 5 is a diagram illustrating the heating procedure.
Fig. 6 is a diagram illustrating the heating procedure.
Fig. 7 is a diagram illustrating the heating procedure.
Fig. 8 is a diagram illustrating the heating procedure.
Fig. 9 is a diagram illustrating a schematic diagram when heating.
Fig. 10 is a diagram illustrating states of a conductor after the conductor is pushed.
Fig. 11 is a diagram illustrating states of the conductor after the conductor is pushed.
Fig. 12 is a diagram illustrating a process of forming upper layers on an adhesion layer partially or wholly composed of an insulating material.
Fig. 13 is a diagram illustrating a process of forming upper layers on the adhesion layer partially or wholly composed of an insulating material.
Fig. 14 is a diagram illustrating a process of forming upper layers on the adhesion layer partially or wholly composed of an insulating material.
Fig. 15 is a diagram illustrating a process of forming upper layers on the adhesion layer partially or wholly composed of an insulating material.
Fig. 16 is a diagram illustrating a process of forming upper layers on the adhesion layer partially or wholly composed of an insulating material.
Fig. 17 is a diagram illustrating a process of forming upper layers on the adhesion layer partially or wholly composed of an insulating material.
Fig. 18 is a diagram illustrating states of a conductor after the conductor is pushed.
Fig. 19 is a diagram illustrating states of the conductor after the conductor is pushed.
Fig. 20 is a diagram illustrating a VIA forming process.
Fig. 21 shows an example of an electronic component mounting substrate according to a second embodiment.
Fig. 22 shows an enlarged view of a boundary part between an adhesion layer and a conductor.
Fig. 23 is an enlarged view showing a first example of unevenness.
Fig. 24 is an enlarged view showing a second example of unevenness.
Fig. 25 shows an example of regularity of unevenness on a surface of the adhesion layer.
Fig. 26 explains a method of manufacturing an electronic component mounting substrate according to the second embodiment.
Fig. 27 is a cross-sectional view of a substrate that can be employed in a fourth embodiment.
Fig. 28 is a plan view of a net-like member which is an anchor body that can be employed in the fourth embodiment.
Fig. 29 is a cross-sectional view showing an aspect where the anchor body is not removed when a metal layer is patterned in the fourth embodiment.
Fig. 30 is a cross-sectional view showing an aspect where the anchor body is removed when the metal layer is patterned in the fourth embodiment.
Fig. 31 is a cross-sectional view showing an example of a substrate that can be employed in a fifth embodiment.
Fig. 32 is a cross-sectional view showing another example of the substrate that can be employed in the fifth embodiment.
Fig. 33 is a cross-sectional view showing an example of a substrate that can be employed in a sixth embodiment.
Fig. 34 is a cross-sectional view showing another example of the substrate that can be employed in the sixth embodiment.

### Description of Embodiments

Embodiments of the present disclosure will be described with reference to the attached drawings. The embodiments described below are working examples of the present disclosure, and the present disclosure is not limited to the embodiments below. In the present description and the drawings, components having the same reference numeral represent components identical to each other.

### (First Embodiment)

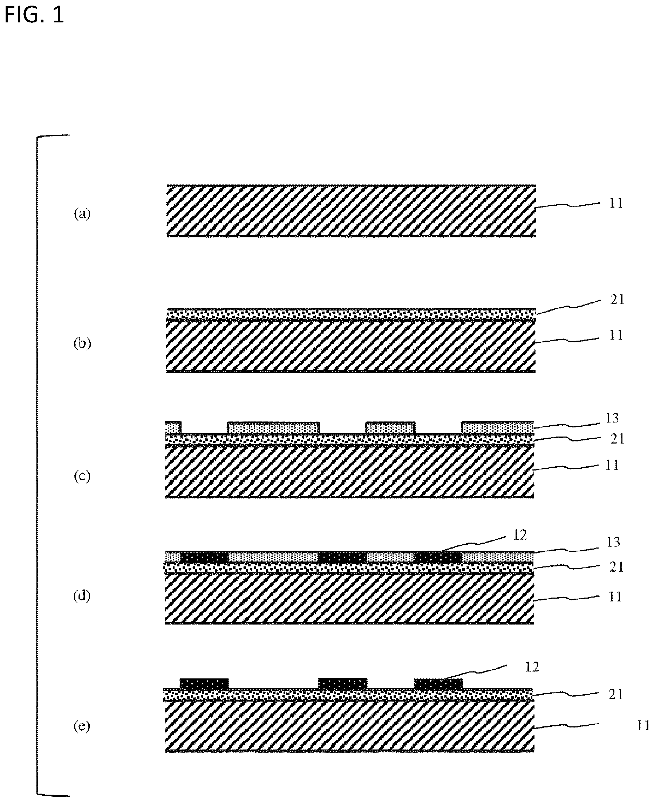

In the present embodiment, a case where an insulator layer is an insulating layer will be described. A method of manufacturing an electronic component mounting substrate according to the present embodiment includes, in order, an adhesion layer forming process and a conductor forming process described below. Figs. 1(a) to 1(e) show an example of an adhesion layer forming process and a conductor forming process which form an adhesion layer partially or wholly composed of an insulating material and a conductor on an insulating layer of the present disclosure. In Figs. 1(a) to 1(e), reference numeral 11 denotes the insulating layer, reference numeral 12 denotes the conductor, reference numeral 13 denotes a pattern resist, and reference numeral 21 denotes the adhesion layer partially or wholly composed of an insulating material.

In the adhesion layer forming process, the adhesion layer 21 is formed on the insulating layer 11. In the conductor forming process, the conductor 12 is formed on an upper surface of the adhesion layer 21. The adhesion layer 21 is formed in at least a part of a region where the conductor 12 is arranged on the insulating layer 11. It is preferable that the adhesion layer 21 is formed in an entire region where the conductor 12 is arranged, and the adhesion layer 21 may be formed on the entire insulating layer 11.

The insulating layer 11 is an insulator that can be used for a printed circuit board. A material used for the insulating layer 11 is, for example, a resin. However, the material is not limited to a resin, but the material may include arbitrary substances such as glass and ceramics having insulation properties. In the insulating layer 11, two or more kinds of insulating substances may be mixed. For example, the insulating layer 11 may include fibrous or granular insulators.

The insulating layer 11 may be an insulator where a resin is mixed with a base material. A thermosetting resin or an ultraviolet curing resin is preferred as the resin. It is possible to use a thermoplastic resin having a certain heat resistance. A polyimide resin, an epoxy resin, a phenol resin, and a cyanate resin can be exemplified as the thermosetting resin. The heat distortion temperature of the thermoplastic resin may be 50°C or more. The higher the distortion temperature, the better. Glass fibers, ceramic particles, and cellulose fibers can be exemplified as the base material. Natural objects such as fibers of a spider's web may also be used as the base material. The base material is not limited to those described above. Further, an insulating layer may be formed by laminating prepregs where the resin described above is impregnated into glass cloths and half-cured and heating and pressurizing the prepregs. The same goes for any of the embodiments described below.

The conductor 12 is a conductor layer formed by an arbitrary material that can be used for a conductor of a printed circuit board and includes a metallic foil, metal plating, and a rolled plate . The materials of the metallic foil and the metal plating included in the conductor 12 are any metals, alloys, or pastes. Alternatively, besides metals, any substances having conductivity such as carbon and ceramics can be used as part or all of the conductor 12. As metals applied to the conductor 12, copper, gold, silver, aluminum, nickel, or alloy or paste containing the highest mass percentage of one of these metals can be exemplified, but not limited to those. The same goes for any of the embodiments described below.

The adhesion layer 21 partially or wholly composed of an insulating material is formed (Fig. 1(b)) on the insulating layer 11 (Fig. 1(a)). Next, a resist is applied to the adhesion layer 21 partially or wholly composed of an insulating material by a known full-additive method or semi-additive method, and a pattern resist 13 is formed in a part other than a part to be finally a conductor (Fig. 1(c)). A conductor is grown in a part other than the remained pattern resist 13 by non-electrolytic plating or the like (Fig. 1(d)). The pattern resist 13 is removed and the conductor 12 is remained (Fig. 1(e)). In the conductor forming process, the conductor 12 patterned on the adhesion layer 21 partially or wholly composed of an insulating material is formed. In the conductor forming process, the conductor may be formed by the full-additive method or the semi-additive method. However, the conductor forming method is not limited to those methods.

The adhesion layer 21 is an arbitrary substance with higher adhesiveness to the conductor 12 than to the insulating layer 11. The adhesion layer 21 is arranged in at least a partial region between the insulating layer 11 and the conductor 12. When the adhesion layer 21 is arranged in at least a partial region between the insulating layer 11 and the conductor 12, it is possible to increase adhesion strength between the insulating layer 11 and the conductor 12, and the adhesion layer 21 may be arranged in the entire region between the insulating layer 11 and the conductor 12. The adhesion layer 21 contains a substance that increases adhesion strength between the insulating layer 11 and the conductor 12. The substance that increases the adhesion strength may be a substance that uses any of chemical interaction, physical interaction, and mechanical coupling. As the mechanical coupling, for example, unevenness described in a second embodiment described later can be exemplified. The adhesion layer 21 may contain a substance, such as a catalyst, which increases at least one of the chemical interaction, the physical interaction, and the mechanical coupling.

As a substance that increases the adhesion strength by the chemical interaction, a substance that is used as an adhesive may be contained in part or all of the adhesion layer 21. For example, as a resin material of the adhesion layer 21 partially or wholly composed of an insulating material, it is possible to use any substance having high adhesiveness to the conductor 12 and the insulating layer 11, such as a polyimide resin, an epoxy resin, a phenol resin, and a cyanate resin, besides inorganic materials. An inorganic substance such as a metal oxide, a metal nitride, a metal carbide, an oxidizing agent, and a reducing agent may be contained in part or all of the adhesion layer 21. It is essential that the adhesion layer itself that is partially or wholly composed of an insulating material has an insulating property.

The same goes for a second adhesion layer partially or wholly composed of an insulating material described later.

As a substance that increases the adhesion strength by the physical interaction, at least either a reducing agent having reduction action or an oxidizing agent having oxidation action may be contained in part or all of the adhesion layer 21. The reducing agent has an action to reduce a substance contained in at least one of the conductor 12, the insulating layer 11, and the adhesion layer 21. The oxidizing agent has an action to oxidize a substance contained in at least one of the conductor 12, the insulating layer 11, and the adhesion layer 21. The reducing agent and the oxidizing agent are reacted not only with the conductor 12, the insulating layer 11, and the adhesion layer 21 but also with a single or mutual combination with a peripheral environment such as air and water and another catalyst.

The reducing agent may be contained in the entire adhesion layer 21, may be contained in only a surface of the adhesion layer 21 facing the conductor 12, or may be contained in only a surface of the adhesion layer 21 facing the insulating layer 11. The same goes for the oxidizing agent. For example, the reducing agent may be contained in the surface of the adhesion layer 21 facing the conductor 12 and the oxidizing agent may be contained in the surface of the adhesion layer 21 facing the insulating layer 11. A ratio of the reducing agent contained in the adhesion layer 21 is optional, and the amount of the reducing agent may be slight as long as the reducing agent has reducing properties. The same goes for the oxidizing agent.

The reducing agent contained in the surface of the adhesion layer 21 facing the insulating layer 11 may be different from or the same as the reducing agent contained in the surface of the adhesion layer 21 facing the conductor 12. As an example where the reducing agents are different from each other, for example, it is possible to employ a configuration where a reducing agent suitable to reduce the conductor 12 is contained in a side of the adhesion layer 21 facing the conductor 12 and a reducing agent suitable to reduce the insulating layer 11 is contained in a side of the adhesion layer 21 facing the insulating layer 11. As the same example, for example, when a substance that functions as a reducing agent is contained between the insulating layer 11 and the conductor 12, it can be said that the adhesion layer 21 according to the present disclosure is included. The same goes for the oxidizing agent.

As a material of the pattern resist 13, a photosensitive dry film, a liquid resist, and an ED resist can be exemplified, but not limited to those. The same goes for any of the embodiments described below. As those materials, there are photocuring type materials and photodissolution type materials.

The adhesion layer 21 partially or wholly composed of an insulating material is formed between the insulating layer 11 and the conductor 12, and thereby the adhesion layer 21 partially or wholly composed of an insulating material is adhered to the insulating layer 11, the conductor 11 is adhered to the adhesion layer 21 partially or wholly composed of an insulating material, and peel strength between the adhesion layer 21 partially or wholly composed of an insulating material and the conductor 12 is improved.

The method of manufacturing an electronic component mounting substrate according to the present disclosure may further include at least either a heating process or a pushing process after the conductor forming process. Thereby, it is possible to further increase the peel strength between the adhesion layer 21 and the conductor 12 and the peel strength between the insulating layer 11 and the adhesion layer 21.

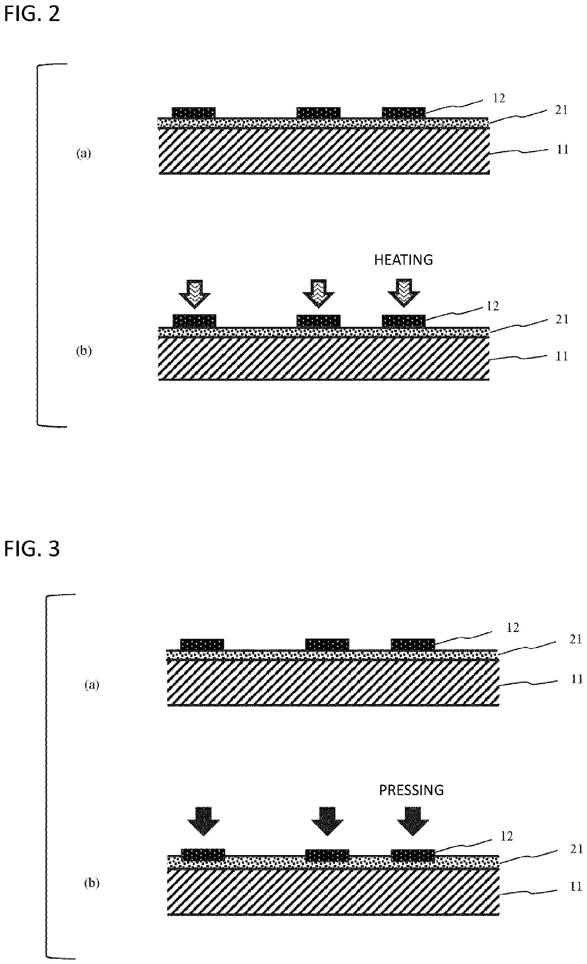

Figs 2 (a) to 2(b) show the heating process that heats at least one of the insulating layer, the adhesion layer partially or wholly composed of an insulating material, and the conductor according to the present disclosure. In Figs 2(a) to 2(b), reference numeral 11 denotes the insulating layer, reference numeral 12 denotes the conductor, and reference numeral 21 denotes the adhesion layer partially or wholly composed of an insulating material.

In the heating process after the conductor forming process, at least one of the insulating layer 11, the adhesion layer 21 partially or wholly composed of an insulating material, and the conductor 12 may be heated. The heating is realized by, for example, pressing a heater, irradiating with LED light or infrared rays, and spraying hot air. The conductor 12 may be heated by using a panel heated by a heater.

At least one of the insulating layer 11, the adhesion layer 21 partially or wholly composed of an insulating material, and the conductor 12 is heated, and thereby the adhesion layer 21 partially or wholly composed of an insulating material is adhered to the insulating layer 11, the conductor 11 is adhered to the adhesion layer 21 partially or wholly composed of an insulating material, and the peel strength between the adhesion layer 21 partially or wholly composed of an insulating material and the conductor 12 is improved.

Figs 3(a) to 3(b) show the pushing process that pushes the conductor into the insulating layer according to the present disclosure. In Figs 3 (a) to 3(b), reference numeral 11 denotes the insulating layer, reference numeral 12 denotes the conductor, and reference numeral 21 denotes the adhesion layer partially or wholly composed of an insulating material. When mechanically pushing the conductor 12 (Fig. 3(a)) formed on a surface of the insulating layer 11 in a direction to the insulating layer 11, a part of the conductor 12 is buried in a surface of the adhesion layer 21 partially or wholly composed of an insulating material (Fig. 3(b)). Fig. 3 (b) is an example of the electronic component mounting substrate of the present disclosure. In the operation of mechanically pushing the conductor 12, for example, all or part of the conductor 12 formed on the surface of the adhesion layer 21 partially or wholly composed of an insulating material is pushed in the insulating layer 11 by using a pressing machine having a planar pressing surface.

When the conductor 12 is pushed in the adhesion layer 21 partially or wholly composed of an insulating material, not only a bottom surface of the conductor 12, but also at least a part of a side surface of the conductor 12 is adhered to the insulating layer 11, so that peel strength between the insulating layer 11 and the conductor 12 is improved.

A method of realizing an electronic component mounting substrate where the conductor 12 is buried in the insulating layer 11 is not limited to mechanically burying the conductor 12 in the insulating layer 11. For example, in the pushing process, both or either of the conductor 12 and the insulating layer 11 are heated, and the conductor 12 may be sunk in the insulating layer 11. Thereby, it is possible to bury the conductor 12 in the insulating layer 11 without applying a force to the conductor 12.

At this time, although the conductor 12 need not be pushed in the insulating layer 11, the conductor 12 may be pushed in the insulating layer 11 by a weak force. Thereby, a position of an upper surface of the conductor 12 can be easily controlled. As described above, the pushing in the present disclosure also includes pushing with a weak force.

There is a gap between the bottom surface of the conductor 12 and an upper surface of the insulating layer 11, and a part of the adhesion layer 21 partially or wholly composed of an insulating material may exist in the gap. The conductor 12 may penetrate the adhesion layer 21 partially or wholly composed of an insulating material. The bottom surface of the conductor 12 that penetrates the adhesion layer 21 partially or wholly composed of an insulating material may be in contact with the upper surface of the insulating layer 11 and further may penetrate the upper surface of the insulating layer 11. When the conductor 12 is deeply pushed, the peel strength between the adhesion layer 21 partially or wholly composed of an insulating material and the conductor 12 is improved.

In the pushing process, when mechanically pushing the conductor 12 in the insulating layer 11, both or either of the conductor 12 and the insulating layer 11 may be heated. This is effective when the insulating layer is too hard and when it is desired to further improve the peel strength. The heating is realized by, for example, pressing a heater, irradiating with LED light or infrared rays, and spraying hot air. The conductor 12 may be mechanically pushed by a panel heated by a heater.

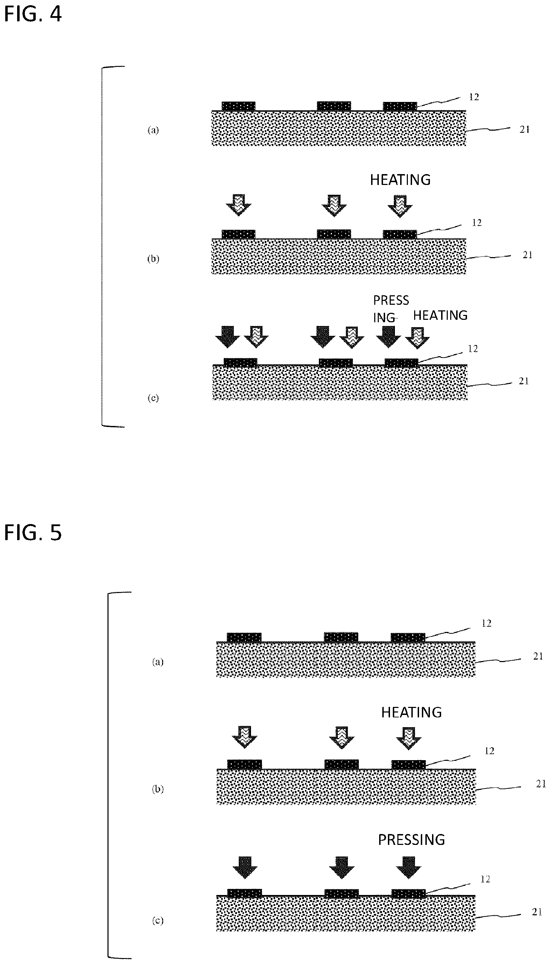

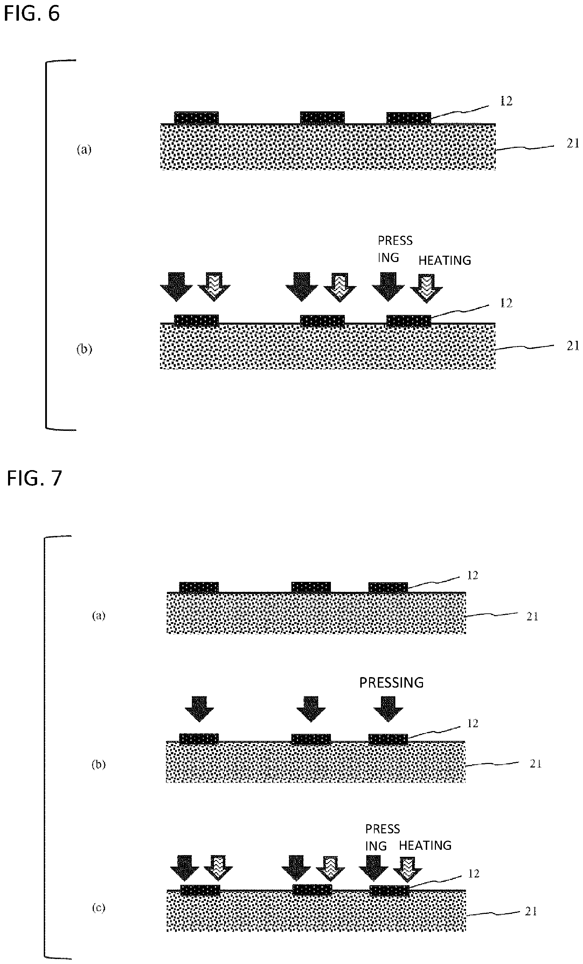

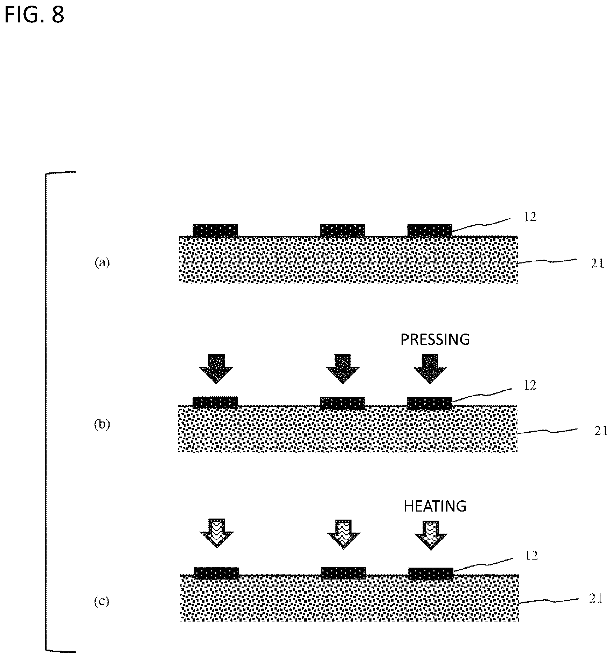

Heating procedures are shown in Fig. 4, Fig. 5, Fig. 6, Fig. 7, and Fig. 8. In Fig. 4, Fig. 5, Fig. 6, Fig. 7, and Fig. 8, reference numeral 12 denotes the conductor, and reference numeral 21 denotes the adhesion layer partially or wholly composed of an insulating material. In Fig. 4, Fig. 5, Fig. 6, Fig. 7, and Fig. 8, (a), (b), and (c) indicate an order. The heating procedure may be a procedure where heating is performed first (Fig. 4(b)), and then the conductor 12 is mechanically pushed in while heating is being performed (Fig. 4(c)). The heating procedure may also be a procedure where heating is performed first (Fig. 5(b)), and then the conductor 12 is mechanically pushed in after the heating is stopped (Fig. 5 (c)). The heating procedure may also be a procedure where heating and mechanical pushing are performed at the same time (Fig. 6(b)). The heating procedure may also be a procedure where mechanical pushing is performed first (Fig. 7(b)), and then heating is performed while the conductor 12 is mechanically pushed in (Fig. 7(c)). The heating procedure may also be a procedure where mechanical pushing is performed first (Fig. 8(b)), and then heating is performed after the mechanical pushing is stopped (Fig. 8(c)).

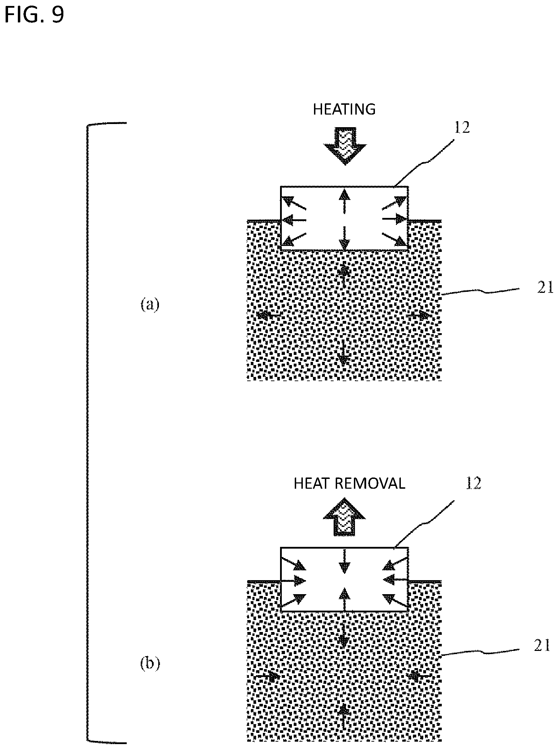

Fig. 9(a) shows a schematic diagram when heating is performed. The conductor 12 is metal and its expansion coefficient is greater than that of the adhesion layer 21 partially or wholly composed of an insulating material. Therefore, when the conductor 12 is heated at an appropriate temperature, the conductor 12 is adhered to the adhesion layer 21 partially or wholly composed of an insulating material, and an anchor effect is obtained. Even if heat is removed thereafter (Fig. 9(b), a degree of adhesion between the conductor 12 and the adhesion layer 21 partially or wholly composed of an insulating material is improved more than before heating. Therefore, the peel strength between the adhesion layer 21 partially or wholly composed of an insulating material and the conductor 12 is improved.

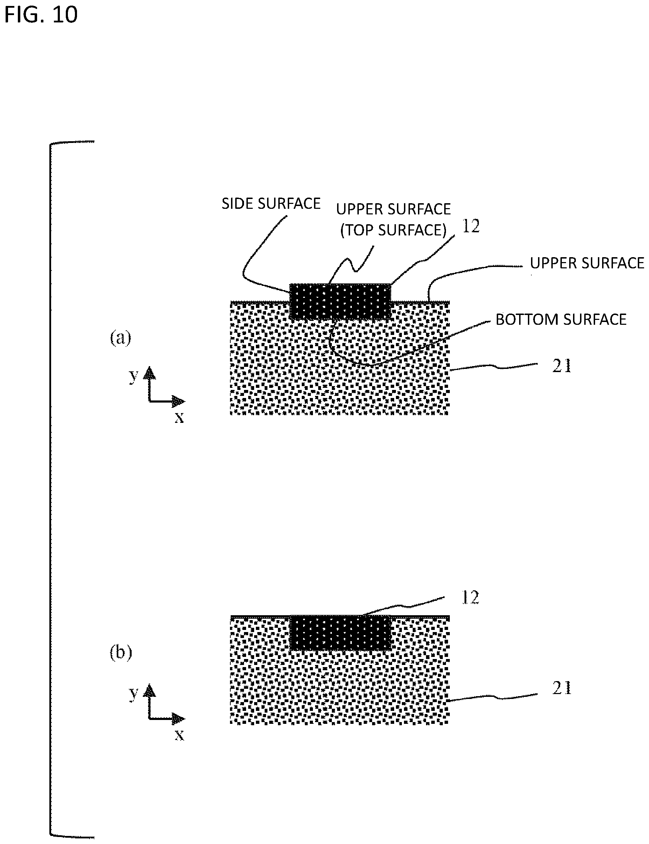

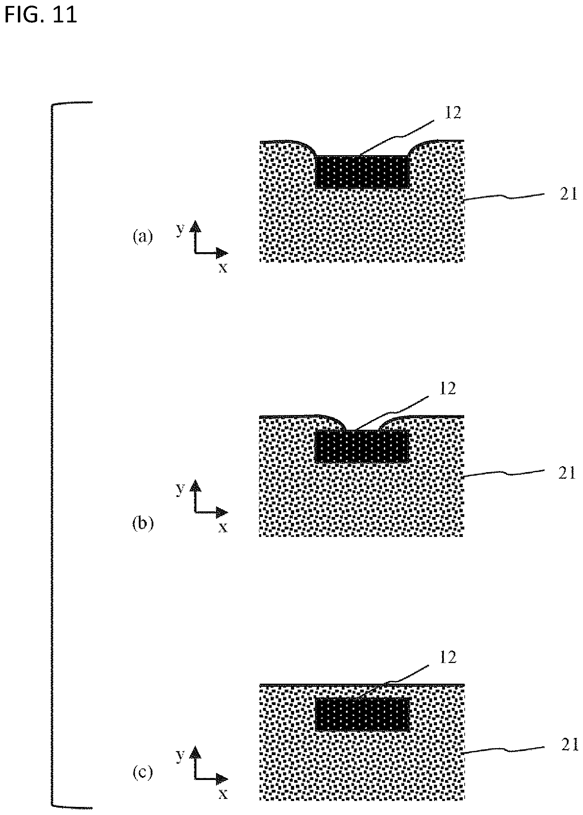

In the pushing process, a state after the conductor is pushed in will be described with reference to Fig. 10 (a), Fig. 10(b), Fig. 11(a), Fig. 11(b), and Fig. 11(c). Fig. 10(a), Fig. 10(b), Fig. 11(a), Fig. 11(b), and Fig. 11(c) are examples of the electronic component mounting substrate of the present disclosure. In Fig. 10(a), Fig. 10(b), Fig. 11(a), Fig. 11(b), and Fig. 11(c), reference numeral 12 denotes the conductor, and reference numeral 21 denotes the adhesion layer partially or wholly composed of an insulating material. In the description thereof, as shown in Fig. 10 (a), in the conductor 12, a surface facing the insulating layer (not shown in Fig. 10(a)) (the surface nearer to the insulating layer) is called a bottom surface, a surface opposite to the bottom surface (the surface farther from the insulating layer) is called an upper surface, and a surface sandwiched by the upper surface and the bottom surface is called a side surface, and in the adhesion layer partially or wholly composed of an insulating material, a surface farther from the insulating layer (not shown in Fig. 10(a)) is called an upper surface.

The conductor 12 may be pushed in to a position where the bottom surface and a part of the side surface of the conductor 12 are lower than the surface of the adhesion layer 21 partially or wholly composed of an insulating material (Fig. 10 (a)). All of the bottom surface and a part of the side surface of the conductor 12 are adhered to the adhesion layer 21 partially or wholly composed of an insulating material, so that the peel strength between the adhesion layer 21 partially or wholly composed of an insulating material and the conductor 12 is improved. The conductor 12 may be pushed in to a position where the upper surface of the conductor 12 has the same level as the surface of the adhesion layer 21 partially or wholly composed of an insulating material (Fig. 10(b)). All of the bottom surface and all of the side surface of the conductor 12 are adhered to the adhesion layer 21 partially or wholly composed of an insulating material, so that the peel strength between the adhesion layer 21 partially or wholly composed of an insulating material and the conductor 12 is further improved.

Further, in a structure shown in Fig. 10(a), in addition to the bottom surface of the conductor 12 that spreads in an x axis direction, a part of the side surface that spreads in a y axis direction is adhered to the adhesion layer 21, so that it is possible to increase the peel strength against to a load applied to the conductor 12 in the x axis direction.

Although Fig. 10(a) shows an example where both the side surfaces arranged on both sides of the bottom surface are buried in the adhesion layer 21, the present disclosure is not limited to this example, and for example, only one of the side surfaces arranged on both sides of the bottom surface may be buried in the adhesion layer 21. Although the upper surface of the conductor 12 spreads in the x axis direction in Fig. 10 (a), the present disclosure is not limited to that, and the upper surface of the conductor 12 may be inclined with respect to the x axis direction.

Although Fig. 10(a) and Fig. 10(b) show examples where a cross-sectional shape of the conductor 12 is rectangle, the cross-sectional shape of the conductor 12 according to the present disclosure is optional. For example, the upper surface of the conductor 12 may be curved, and a boundary between the side surface and the upper surface may form a continuous curved line.

The conductor 12 may be pushed in to a position where not only the bottom surface and the side surface of the conductor 12, but also the upper surface is lower than the upper surface of the adhesion layer 21 partially or wholly composed of an insulating material (Fig. 11(a), Fig. 11(b), and Fig. 11(c)). In Fig. 11(a), the conductor 12 is pushed in to a position where the upper surface of the conductor 12 is lower than the upper surface of the adhesion layer 21 partially or wholly composed of an insulating material. However, the upper surface of the conductor 12 is exposed. All of the bottom surface and all of the side surface of the conductor 12 are adhered to the adhesion layer 21 partially or wholly composed of an insulating material, so that the peel strength between the adhesion layer 21 partially or wholly composed of an insulating material and the conductor 12 is further improved. In Fig. 11(b), the conductor 12 is pushed in to a position where the upper surface of the conductor 12 is lower than the upper surface of the adhesion layer 21 partially or wholly composed of an insulating material. However, a part of the upper surface of the conductor 12 is exposed. All of the bottom surface, all of the side surface, and a part of the upper surface of the conductor 12 are adhered to the adhesion layer 21 partially or wholly composed of an insulating material, so that the peel strength between the adhesion layer 21 partially or wholly composed of an insulating material and the conductor 12 is even further improved. In Fig. 11(c), the conductor 12 is pushed in to a position where the upper surface of the conductor 12 is lower than the upper surface of the adhesion layer 21 partially or wholly composed of an insulating material, and the upper surface of the conductor 12 is also buried in the adhesion layer 21 partially or wholly composed of an insulating material. All of the bottom surface, all of the side surface, and all of the upper surface of the conductor 12 are adhered to the adhesion layer 21 partially or wholly composed of an insulating material, so that the peel strength between the adhesion layer 21 partially or wholly composed of an insulating material and the conductor 12 is still further improved.

In Fig. 10(a), Fig. 10(b), and Fig. 11(a), three surfaces of the conductor 12 are adhered to the adhesion layer 21. When there is the same structure in a y-z plane, five surfaces of the conductor 12 are adhered to the adhesion layer 21. In this way, in addition to the bottom surface of the conductor 12 that spreads in an x axis direction, a part or all of the side surfaces of the conductor 12 that spread in the y axis direction is adhered to the adhesion layer 21, so that it is possible to increase the peel strength against to a load applied to the conductor 12 in the x and z axis directions.

In Fig. 11(b) and Fig. 11(c), four surfaces of the conductor 12 are adhered to the adhesion layer 21. When there is the same structure in the y-z plane, six surfaces of the conductor 12 are adhered to the adhesion layer 21. In this way, in addition to the bottom surface of the conductor 12 that spreads in the x axis direction, a part or all of the side surfaces of the conductor 12 that spread in the y axis direction and a part or all of the upper surface of the conductor 12 that spread in the x axis direction are adhered to the adhesion layer 21, so that it is possible to increase the peel strength against to a load applied to the conductor 12 in the x, y, and z axis directions.

Although Fig. 10 and Fig. 11 show an example where the bottom surface of the conductor 12 is adhered to the adhesion layer 21, the present disclosure is not limited to this example. For example, the present disclosure includes a form where a part or all of the bottom surface of the conductor 12 is exposed to a back surface of the adhesion layer 21 and two surfaces of the conductor 12 are adhered to the adhesion layer 21 in Fig. 10(a), Fig. 10(b), and Fig. 11(a). When there is the same structure in the y-z plane, four surfaces of the conductor 12 are adhered to the adhesion layer 21. In this case, a part or all of the side surfaces of the conductor 12 that spread in the y axis direction is adhered to the adhesion layer 21, so that it is possible to increase the peel strength against to a load applied to the conductor 12 in the x and z axis directions.

Further, the present disclosure includes a form where all of the bottom surface of the conductor 12 is exposed to the back surface of the adhesion layer 21 and three surfaces of the conductor 12 are adhered to the adhesion layer 21 in Fig. 11(b) . When there is the same structure in the y-z plane, five surfaces of the conductor 12 are adhered to the adhesion layer 21. In this case, a part of the upper surface of the conductor 12 that spreads in the x axis direction and a part or all of the side surfaces of the conductor 12 that spread in the y axis direction are adhered to the adhesion layer 21, so that it is possible to increase the peel strength against to a load applied to the conductor 12 in the x, y, and z axis directions.

Further, the present disclosure includes a form where a part of the bottom surface of the conductor 12 is exposed to the back surface of the adhesion layer 21 and four surfaces of the conductor 12 are adhered to the adhesion layer 21 in Fig. 11(b). When there is the same structure in the y-z plane, six surfaces of the conductor 12 are adhered to the adhesion layer 21. In this case, a part of the upper surface of the conductor 12 that spreads in the x axis direction, all of the side surfaces of the conductor 12 that spread in the y axis direction, and a part of the bottom surface of the conductor 12 that spreads in the x axis direction are adhered to the adhesion layer 21, so that it is possible to increase the peel strength against to a load applied to the conductor 12 in the x, y, and z axis directions.

### (Second Embodiment)

In the present embodiment, an example will be described where the electronic component mounting substrate described in the first embodiment is a multilayer substrate in which layers of combination of an insulating layer and conductors are formed on an insulating layer. In the electronic component mounting substrate according to the present embodiment, an adhesion layer is provided to the layers of combination.

Specifically, the present embodiment describes an electronic component mounting substrate that includes an insulating layer, an adhesion layer partially or wholly composed of an insulating material which is formed on an upper surface of the insulating layer and adhered to the insulating layer, a conductor formed on the adhesion layer partially or wholly composed of an insulating material and one or more layers of combination of an insulating layer and conductors formed in the insulating layer over the conductor and the adhesion layer partially or wholly composed of an insulating material.

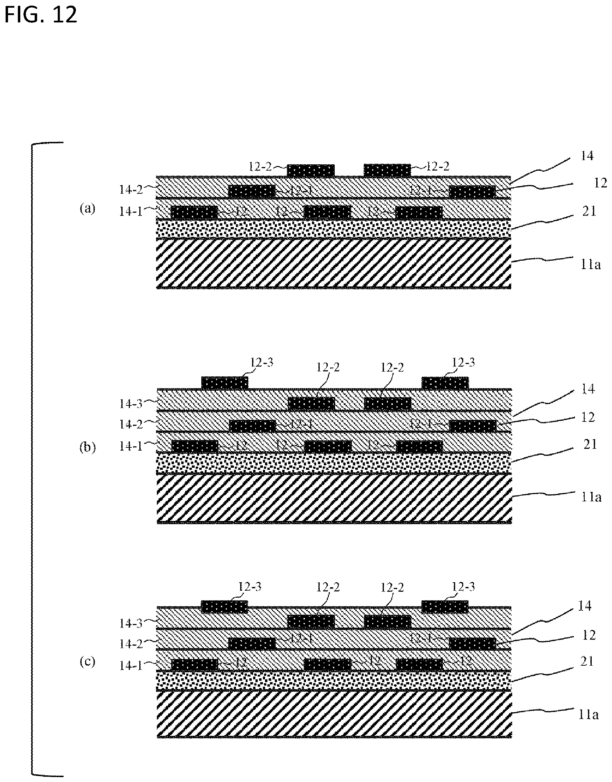

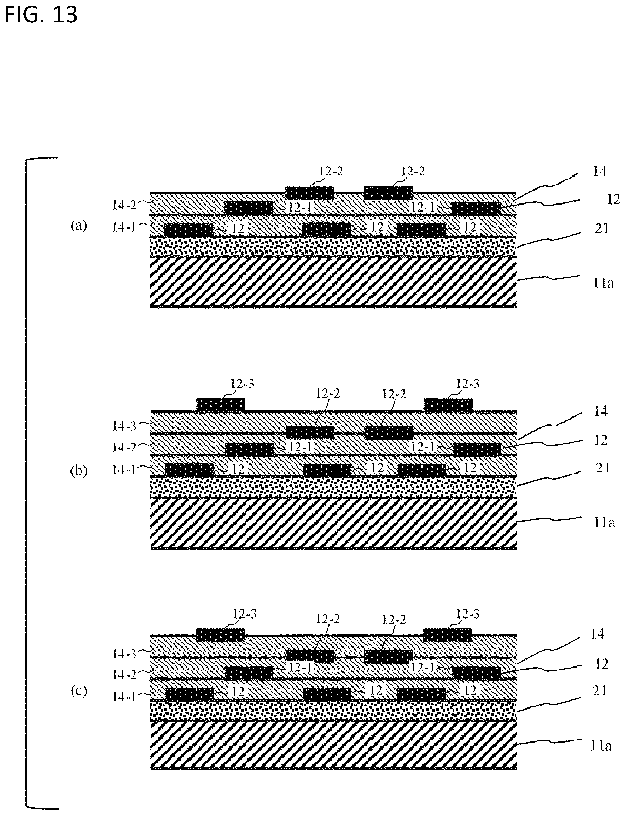

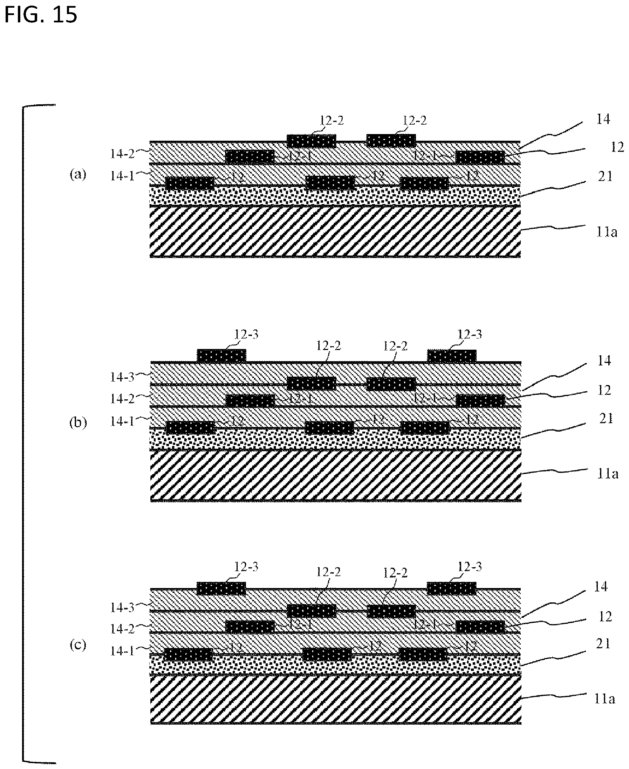

In Fig. 12, Fig. 13, Fig. 14, Fig. 15, Fig. 16, and Fig. 17, reference numeral 11a denotes a laminated insulating layer, reference numeral 12 denotes a conductor, reference numeral 14 denotes a laminated insulating layer, reference numeral 21a denotes a first adhesion layer partially or wholly composed of an insulating material, and reference numeral 22 denotes a second adhesion layer partially or wholly composed of an insulating material. A plurality of laminated insulating layers 11a and 14 form an insulating layer. The first adhesion layer 21a and the second adhesion layer 22 form a laminated adhesion layer. A plurality of laminated insulating layers form an adhesion layer.

Figs. 12 to 15 show an example that forms a layer of combination of a laminated insulating layer 14-1 and conductors 12-1, a layer of combination of a laminated insulating layer 14-2 and conductors 12-2, and a layer of combination of a laminated insulating layer 14-3 and conductors 12-3 as an example of a combination of the laminated insulating layers 14 and the conductors 12. In Figs. 12 to 15, the adhesion layer 21 is provided between the laminated insulating layer 11a and the conductors 12 formed over the laminated insulating layer 11a. The adhesion layer may be provided between the laminated insulating layer 14-1 and the conductors 12-1 that form a layer of combination.

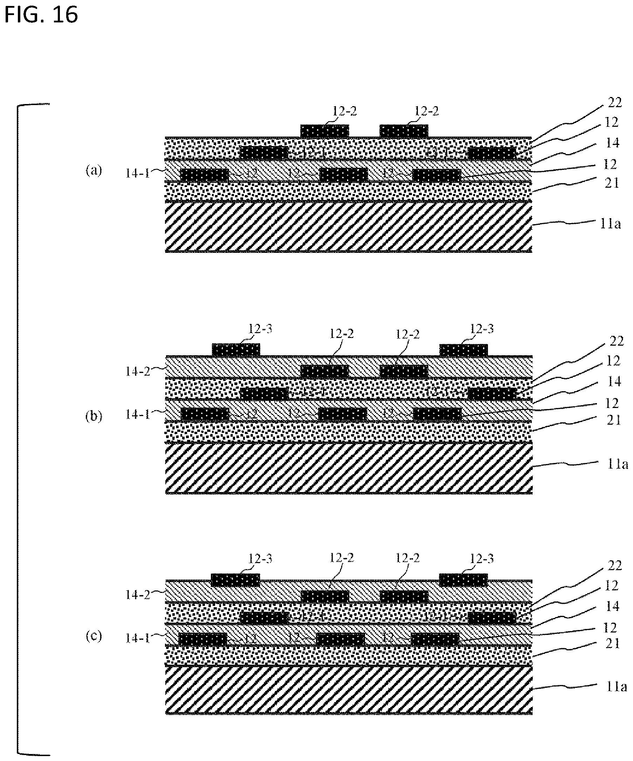

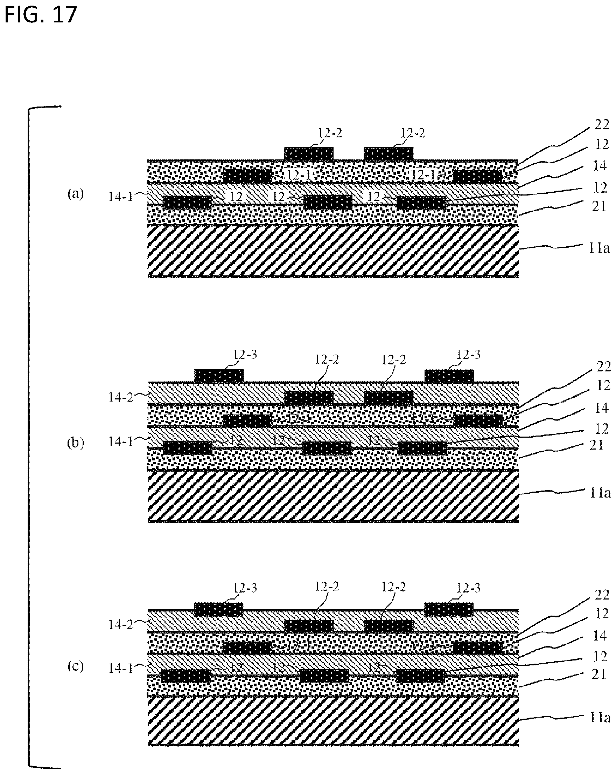

Fig. 16 and Fig. 17 show an example that forms the layer of combination of the laminated insulating layer 14-1 and the conductors 12-1, and the layer of combination of the laminated insulating layer 14-3 and the conductors 12-3 as an example of a combination of the laminated insulating layers 14 and the conductors 12. In Fig. 16 and Fig. 17, a layer of combination of the adhesion layer 22 and the conductors 12-2 is formed instead of the layer of combination of the laminated insulating layer 14-2 and the conductors 12-2. In this way, the adhesion layer 22 is provided between the conductors 12-1 formed on the laminated insulating layer 14-1 that form a layer of combination and the laminated insulating layer 14-2 formed over the conductors 12-1. Although Fig. 16 and Fig. 17 show an example where the adhesion layer 21 is provided between the laminated insulating layer 11a and the conductors 12, the present disclosure also includes a form where the adhesion layer 22 is included in one of the layers of combination and the adhesion layer 21 is not included.

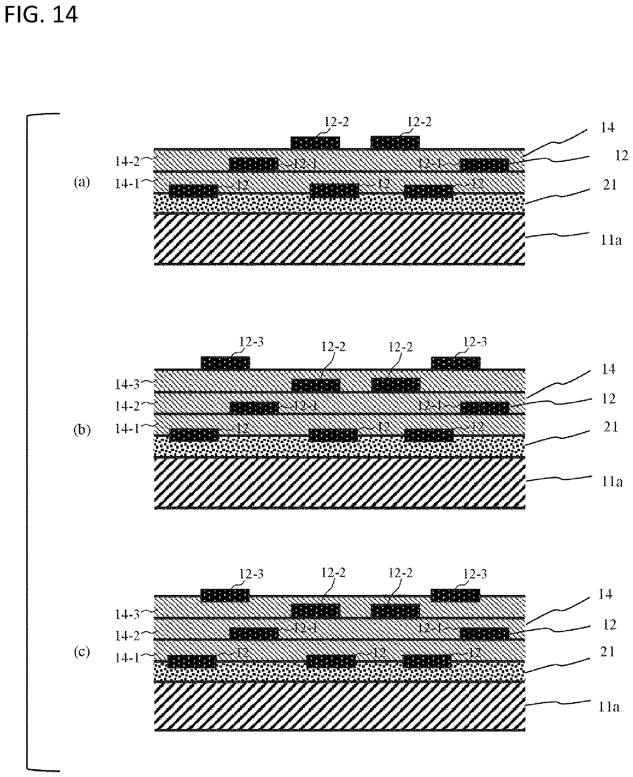

Fig. 12, Fig. 13, and Fig. 16 are manufacturing processes of the electronic component mounting substrate where the conductors 12 are formed on the upper surface of the adhesion layer 21 partially or wholly composed of an insulating material. Fig. 14, Fig. 15, and Fig. 17 are manufacturing processes of the electronic component mounting substrate where the conductors 12 are formed on the upper surface of the adhesion layer 21 partially or wholly composed of an insulating material and the conductors 12 are pushed in the adhesion layer 21 partially or wholly composed of an insulating material. Fig. 16 and Fig. 17 are manufacturing processes of the electronic component mounting substrate where the second adhesion layer 22 partially or wholly composed of an insulating material and the conductors 12 are further formed.

Here, a second conductor forming process will be described first. In the second conductor forming process, the adhesion layer 21 partially or wholly composed of an insulating material is formed and the laminated insulating layer 14 and the conductors 12 are formed over the conductors 12 formed on the upper surface of the adhesion layer 21 partially or wholly composed of an insulating material (Fig. 12(a), Fig. 13(a), Fig. 14(a), Fig. 15(a), Fig. 16(a), and Fig. 17(a)). The second conductor forming process is repeated for a required number of times.

Materials of the laminated insulating layer 14 may be the same as those that can be applied to the insulating layer. The same goes for any of the embodiments described below.

After the conductor forming process, there may be a third conductor forming process before or after the second conductor forming process (Fig. 16(a), Fig. 17(a)). In the third conductor forming process, the second adhesion layer 22 partially or wholly composed of an insulating material is formed and further the conductors 12 are formed on the second adhesion layer 22. As the materials of the second adhesion layer 22 partially or wholly composed of an insulating material, the same materials as those of the adhesion layer 21 partially or wholly composed of an insulating material can be applied. The adhesion layer 21 partially or wholly composed of an insulating material and each second adhesion layer 22 partially or wholly composed of an insulating material may have the same materials or different materials.

When the third conductor forming process is performed, the electronic component mounting substrate of the present disclosure further includes one or more layers of combination of the second adhesion layer 22 partially or wholly composed of an insulating material and the conductors 12 formed on the second adhesion layer 22 partially or wholly composed of an insulating material, which are adhered to each other, between the two laminated insulating layers 14.

In the conductor forming process, the second conductor forming process, and the third conductor forming process, the conductors may be formed by the full-additive method or the semi-additive method. However, the conductor forming method is not limited to those methods.

After the conductor forming process, after the second conductor forming process, or after the third conductor forming process, a heating process which heats at least one of the laminated insulating layer 11a, the adhesion layer 21 partially or wholly composed of an insulating material, the laminated insulating layer 14, the second adhesion layer 22 partially or wholly composed of an insulating material, and the conductors 12 may be performed. The peel strength between each layer where the conductors 12 are formed and the conductors 12 is improved.

A pushing process may be performed ((Fig. 12(c), Fig. 13(c), Fig. 14(c), Fig. 15(c), Fig. 16(c), or Fig. 17(c)) after the second conductor forming process ((Fig. 12(b), Fig. 13(b), Fig. 14(b), Fig. 15(b), Fig. 16(b), or Fig. 17(b)) that forms the uppermost laminated insulating layer 14 and conductors 12. The uppermost layer may be a combination of the second adhesion layer 22 partially or wholly composed of an insulating material and the conductors 12. In the pushing process in which the conductors 12 are pushed in or sunk in the uppermost laminated insulating layer 14 or the second adhesion layer 22 partially or wholly composed of an insulating material, after the uppermost laminated insulating layer 14 or the second adhesion layer 22 partially or wholly composed of an insulating material is formed, the uppermost conductors 12 are mechanically pushed in or sunk in the laminated insulating layer 14 or the second adhesion layer 22 partially or wholly composed of an insulating material.

The pushing process may be performed after the conductor forming process, the second conductor forming process, or the third conductor forming process. In the pushing process, at least one of the conductors 12 is mechanically pushed in or sunk in the adhesion layer 21 partially or wholly composed of an insulating material, the laminated insulating layer 14, or the second adhesion layer 22 partially or wholly composed of an insulating material.

In the pushing process, when the conductors 12 are mechanically pushed in or sunk in the adhesion layer 21 partially or wholly composed of an insulating material, the laminated insulating layer 14, or the second adhesion layer 22 partially or wholly composed of an insulating material, at least any one of the laminated insulating layer 11a, the adhesion layer 21 partially or wholly composed of an insulating material, the laminated insulating layer 14, or the second adhesion layer 22 partially or wholly composed of an insulating material, and the conductors 12 may be heated. The heating can be realized by pressing a heater, irradiating with infrared rays, or spraying hot air. The conductors 12 may be mechanically pushed in by a panel heated by a heater. The heating procedure can be the same procedure shown in Fig. 4, Fig. 5, Fig. 6, Fig. 7, or Fig. 8.

In the electronic component mounting substrate of the present disclosure, an insulating layer and an insulating layer may be integrated together. Alternatively, when there are a plurality of adjacent insulating layers, the adjacent insulating layers are integrated together.

In the pushing process, a state after the conductors 12 are pushed in the adhesion layer 21 partially or wholly composed of an insulating material or the second adhesion layer 22 partially or wholly composed of an insulating material is the same as those shown in Fig. 10 (a), Fig. 10(b), Fig. 11(a), Fig. 11(b), and Fig. 11(c).

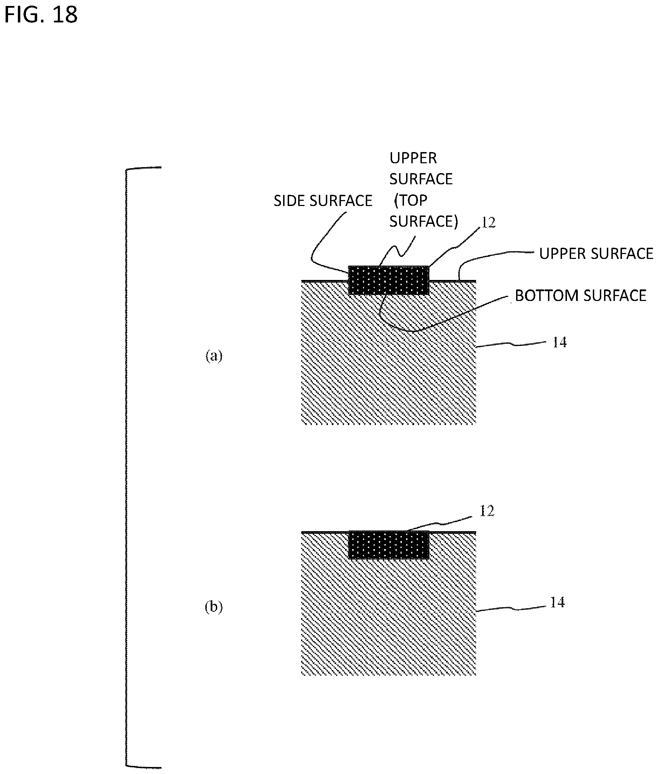

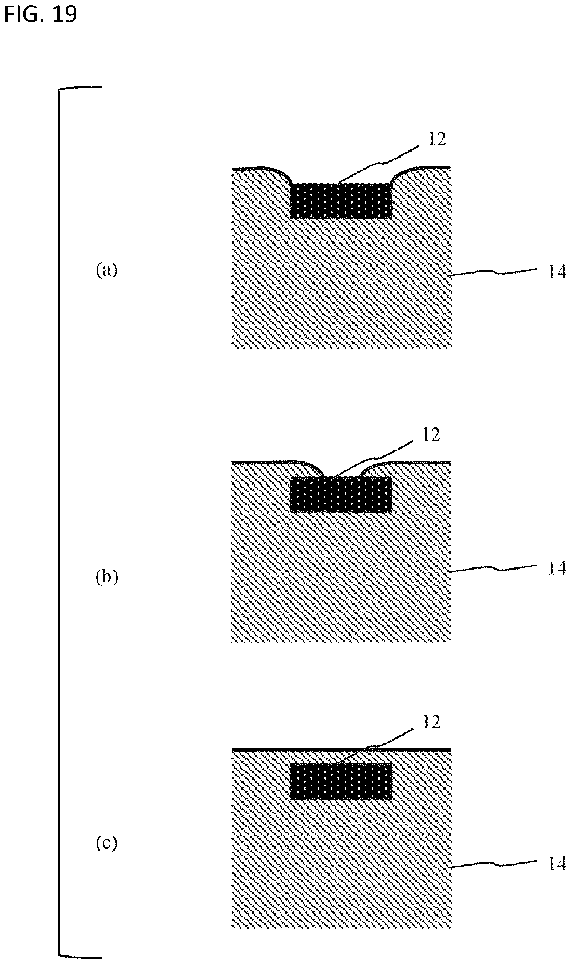

The state after the conductors are pushed in the insulating layer will be described with reference to Fig. 18(a), Fig. 18(b), Fig. 19(a), Fig. 19(b), and Fig. 19(c). Fig. 18(a), Fig. 18(b), Fig. 19(a), Fig. 19(b), and Fig. 19(c) are examples of the electronic component mounting substrate of the present disclosure. In Fig. 18(a), Fig. 18(b), Fig. 19(a), Fig. 19(b), and Fig. 19(c), reference numeral 12 denotes the conductor and reference numeral 14 denotes the insulating layer. In these descriptions, as shown in Fig. 18(a), in the conductor 12, a surface facing the laminated insulating layer 11a (the surface nearer to the laminated insulating layer 11a) is called a bottom surface, a surface opposite to the bottom surface (the surface farther from the laminated insulating layer 11a) is called an upper surface, and a surface sandwiched between the upper surface and the bottom surface is called a side surface. Also in the laminated insulating layer 14, the surface farther from the insulating layer is called an upper surface.

The conductor 12 may be pushed in to a position where the bottom surface and a part of the side surface of the conductor 12 are lower than the upper surface of the laminated insulating layer 14 (Fig. 18(a)). All of the bottom surface and a part of the side surface of the conductor 12 are adhered to the laminated insulating layer 14, so that the peel strength between the laminated insulating layer 14 and the conductor 12 is improved. The conductor 12 may be pushed in to a position where the upper surface of the conductor 12 has the same level as the upper surface of the laminated insulating layer 14 (Fig. 18(b)). All of the bottom surface and all of the side surface of the conductor 12 are adhered to the laminated insulating layer 14, so that the peel strength between the laminated insulating layer 14 and the conductor 12 is further improved.

The conductor 12 may be pushed in to a position where not only the bottom surface and the side surface of the conductor 12, but also the upper surface is lower than the upper surface of the laminated insulating layer 14 (Fig. 19(a), Fig. 19(b), and Fig. 19(c)). In Fig. 19(a), the conductor 12 is pushed in to a position where the upper surface of the conductor 12 is lower than the upper surface of the laminated insulating layer 14. However, the upper surface of the conductor 12 is exposed. All of the bottom surface and all of the side surface of the conductor 12 are adhered to the laminated insulating layer 14, so that the peel strength between the laminated insulating layer 14 and the conductor 12 is further improved. In Fig. 19(b), the conductor 12 is pushed in to a position where the upper surface of the conductor 12 is lower than the upper surface of the laminated insulating layer 14. However, a part of the upper surface of the conductor 12 is exposed. All of the bottom surface, all of the side surface, and a part of the upper surface of the conductor 12 are adhered to the laminated insulating layer 14, so that the peel strength between the laminated insulating layer 14 and the conductor 12 is even further improved. In Fig. 11(c), the conductor 12 is pushed in to a position where the upper surface of the conductor 12 is lower than the upper surface of the laminated insulating layer 14, and the upper surface of the conductor 12 is also buried in the laminated insulating layer 14. All of the bottom surface, all of the side surface, and all of the upper surface of the conductor 12 are adhered to the laminated insulating layer 14, so that the peel strength between the laminated insulating layer 14 and the conductor 12 is still further improved.

When the uppermost conductor is pushed in or sunk in the laminated insulating layer 14 or the second adhesion layer 22 partially or wholly composed of an insulating material, in the electronic component mounting substrate as a final product, the peel strength between the laminated insulating layer 14 or the second adhesion layer 22 partially or wholly composed of an insulating material and the conductor 12 is improved. When a conductor other than the uppermost conductor is pushed in or sunk in the adhesion layer 21 partially or wholly composed of an insulating material, the laminated insulating layer 14, or the second adhesion layer 22 partially or wholly composed of an insulating material, in a manufacturing process of the electronic component mounting substrate, the peel strength between the adhesion layer 21 partially or wholly composed of an insulating material, the laminated insulating layer 14, or the second adhesion layer 22 partially or wholly composed of an insulating material and the conductor 12 is improved, and it is possible to prevent the conductor from being peeled off in the manufacturing process.

The conductor forming process and the second conductor forming process have a pushing process. The pushing process may include a VIA forming process which forms a VIA that electrically connects conductors formed in different layers among conductors formed in a layer of combination. After the VIA forming process, the conductors are mechanically pushed in or sunk in an insulating layer.

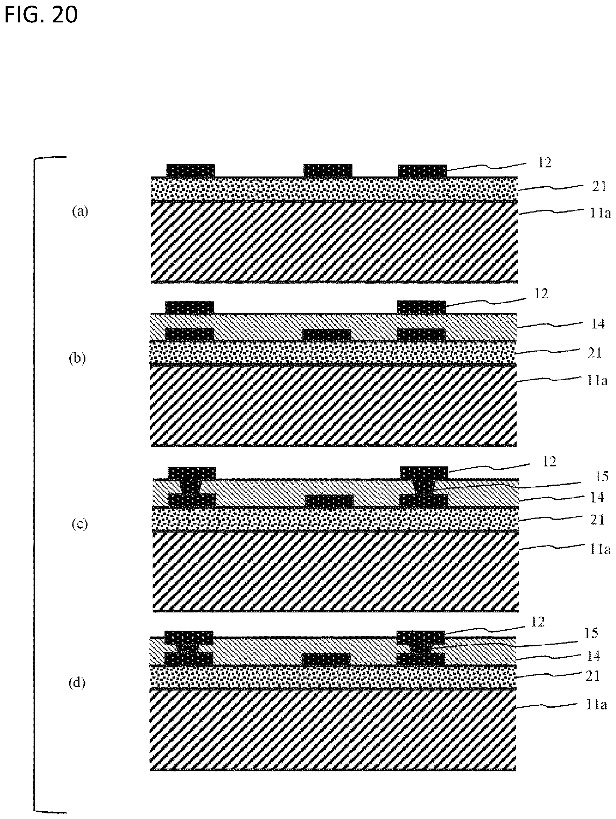

The VIA that electrically connects conductors formed in different layers among the conductors 12 formed in a layer of combination in the laminated insulating layer 14. Fig. 20(a), Fig. 20(b), Fig. 20(c), and Fig. 20(d) show the VIA forming process. In Fig. 20(a), Fig. 20(b), Fig. 20(c), and Fig. 20(d), reference numeral 11a denotes the laminated insulating layer 1, reference numeral 21 denotes the adhesion layer partially or wholly composed of an insulating material, reference numeral 12 denotes the conductor, reference numeral 14 denotes the insulating layer, reference numeral 15 denotes the VIA.

In the conductor forming process and the second conductor forming process, the conductors 12 are sequentially formed on each layer (Fig. 20(a) and Fig. 20(b)). The conductors 12 formed on different layers are electrically connected by the VIA (Fig. 20(c)). After this, when the conductors 12 are mechanically pushed in or sunk in the laminated insulating layer 14, the VIA is compressed and an anchor effect is increased, so that the peel strength between the laminated insulating layer 14 and the conductor 12 is improved. Here, the VIA that electrically connects the conductor 12 on the adhesion layer 21 partially or wholly composed of an insulating material with the conductor 12 on the laminated insulating layer 14 has been described. However, the same goes for the VIA that electrically connects the conductor 12 on the laminated insulating layer 14 or the second adhesion layer 22 partially or wholly composed of an insulating material with the conductor 12 on a resin laminated insulating layer 14 or the second adhesion layer 22 partially or wholly composed of an insulating material. The same goes for the VIA that electrically connects the conductor on the uppermost layer with the conductor on the layer immediately below the uppermost layer.

In the above description, the conductors 12 are mechanically pushed in the laminated insulating layer 14 after the VIA forming process. However, it is needless to say that the VIA 15 may be formed after the conductor 12 is mechanically pushed in the second adhesion layer 22 partially or wholly composed of an insulating material.

The above embodiments are described while one side of an insulating layer is shown. However, the technique of the present disclosure can be applied to not only a single-sided substrate, but also each of both sides of an insulating layer when a double-sided substrate or a multilayered substrate is used. In the case of the double-sided substrate or the multilayered substrate, it may be regarded that the upper layer and the upper surface are a layer and a surface farther from the insulating layer.

In the case of the multilayered substrate, an arbitrary conductor among a conductor on the insulating layer, a conductor on an outermost layer that is farthest from the insulating layer, and a conductor on an arbitrary layer between the insulating layer and the outermost layer may be pushed in the insulating layer and the insulating layer. For example, a form where a conductor on the outermost layer is pushed in and a conductor on an intermediate layer between the insulating layer and the outermost layer is pushed in and a form where a conductor on an intermediate layer between the insulating layer and the outermost layer is pushed in are also included.

In the case of the double-sided substrate or the multilayered substrate, when conductors on both sides are pushed in or sunk in, the conductors may be pushed in by applying pressure to the conductors from both sides at the same time.

In addition, there is a fact that when making a thin printed circuit board, copper foil is easily damaged, so that copper foil with carrier has to be used. This fact also includes a first problem that the price of the copper foil with carrier is high, a second problem that fraction defective is high, and a third problem that a request level to management of the manufacturing process is high. According to the present disclosure, it is possible to make a single layer printed circuit board or a multilayer printed circuit board of which thickness is small without using the copper foil with carrier. Further, a build-up method that makes VIA or a through-hole method that makes through-hole can be used in the technique of the present disclosure.

### (Third Embodiment)

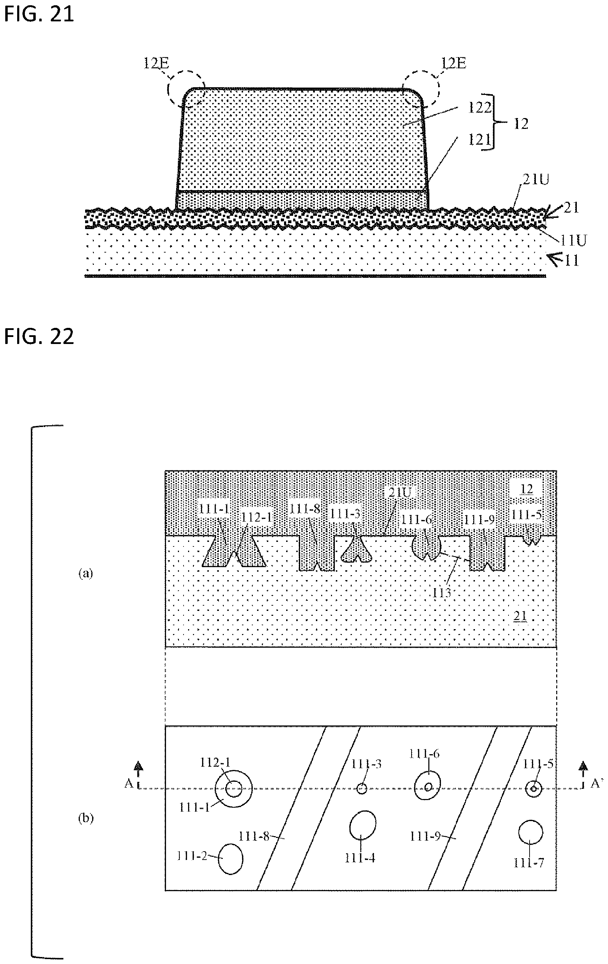

Fig. 21 shows an example of an electronic component mounting substrate according to an embodiment of the present disclosure. The conductor 12 includes an electroless plating layer 121 in a lowermost layer facing the adhesion layer 21. For example, in the conductor 12, the electroless plating layer 121 and an electrolytic plating layer 122 are laminated in order from the lowermost layer facing the adhesion layer 21. In this way, the adhesion layer 21 and the electroless plating layer 121 are in contact with each other, so that it is possible to increase adhesion strength between the adhesion layer 21 and the conductor 12.

The electroless plating layer 121 is an arbitrary conductor formed by an arbitrary method other than electrolytic plating. Fig. 21 shows an example where the electrolytic plating layer 122 is laminated on the electroless plating layer 121. However, there may be a form where the entire conductor 12 is formed by the electroless plating layer 121 without arranging the electrolytic plating layer 122.

Fig. 22 shows an enlarged view of a boundary part between the adhesion layer 21 and the conductor 12. Fig. 22(b) shows a cross-sectional shape on a surface 21U of the adhesion layer 21. Fig. 22(a) shows a cross-sectional shape taken along line A-A'. The adhesion layer 21 has unevenness on the surface 21U facing the conductor 12. The unevenness can be a recessed part or a protruded part or both of them.

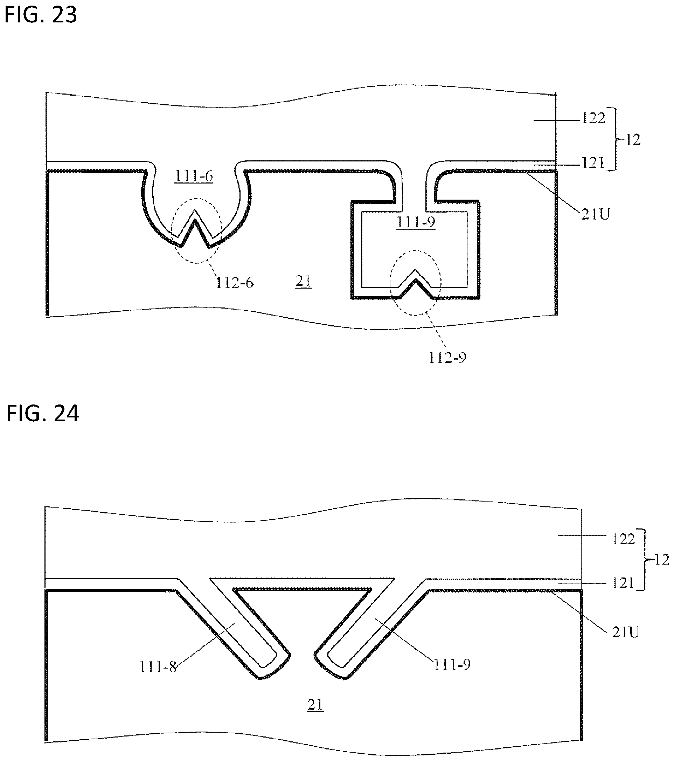

In the present embodiment, unevenness is formed on the surface 21U of the adhesion layer 21, and the electroless plating layer 121 is formed from above the unevenness. Therefore, as shown in Fig. 23, the electroless plating layer 121 grows from a lower part of the conductor 12 arranged on the side of the adhesion layer 21 and directly comes into contact with the surface 21U of the adhesion layer 21. Here, protruded parts denoted by reference numerals 112-6 and 112-9 may or may not be formed.

When a protruded shape is formed on the conductor 12 to obtain an anchor effect, granular substances such as Ni and Fe to form the protruded shape are contained between the surface 21U of the adhesion layer 21 and the electroless plating layer 121. On the other hand, in the present disclosure, unevenness is formed on the surface 21U of the adhesion layer 21, so that granular substances to form the protruded shape on the conductor 12 are not contained. Therefore, the content of substances different from the electroless plating layer 121 in the lowermost layer of the conductor 12 is 30% or less. For example, in the lowermost layer of the conductor 12 of the present disclosure, the electroless plating layer 121 is formed of a single substance. Here, the "single substance" includes metal and alloy. Further, for conductor protruded parts from the conductor 12 to the adhesion layer 21, a conductive part in the adhesion layer 21 such as a tunnel 113 shown in Fig. 22 is not formed. That is to say, the electroless plating layer 121 is formed only on one side of the surface 21U of the adhesion layer 21.

When an anchor is formed by using a protruded shape formed on the conductor 12, the conductor 12 grows from the position of the conductor 12 toward a center direction of the adhesion layer 21. Therefore, the conductor 12 becomes thinner from the vicinity of the surface 21U of the adhesion layer 21 where the conductor 12 is arranged toward the center direction of the adhesion layer 21. On the other hand, in the present disclosure, unevenness is formed on the surface 21U of the adhesion layer 21, so that there may be not only a shape where the conductor 12 becomes thinner from the vicinity of the surface 21U of the adhesion layer 21 toward the center direction of the adhesion layer 21, but also a shape spreading from the vicinity of the surface 21U of the adhesion layer 21 toward the center direction of the adhesion layer 21 such as shapes as shown by recessed parts 111-1, 111-3, and 111-6 in Fig. 22. In this case, the largest spread of conductor protruded part from the conductor 12 to the adhesion layer 21 is arranged in the adhesion layer 21.

As shown in Fig. 24, recessed parts 111-8 and 111-9 in Fig. 22 may be obliquely formed from the vicinity of the surface 21U of the adhesion layer 21 toward the center direction of the adhesion layer 21. In this case, it is preferable that the distance between the recessed part 111-8 and the recessed part 111-9 is shorter in a deep area of the adhesion layer 21 than the vicinity of the surface 21U. Thereby, the recessed part 111-8 and the recessed part 111-9 hold the adhesion layer 21, so that it is possible to further increase the peel strength between the conductor 12 and the adhesion layer 21.

In the present disclosure, unevenness is formed on the surface 21U of the adhesion layer 21, so that arrangement of the unevenness on the surface 21U of the adhesion layer 21 has a regularity caused by a forming method of the unevenness.

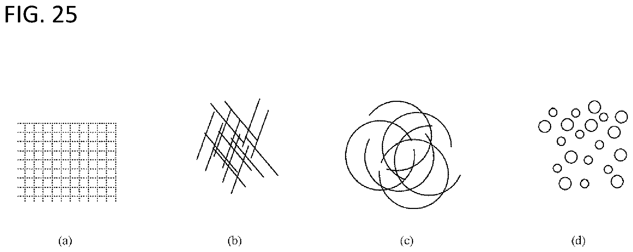

When unevenness is formed by using uneven shapes formed on a plane or a roll, the uneven shapes of the plane or the roll directly appear on the surface 21U. For example, when the uneven shapes include straight lines with a constant width or constant intervals, recessed parts or protruded parts with a constant width or constant intervals remain as shown by reference numerals 111-8 and 111-9 in Fig. 22 or as shown in Fig. 25(a). When unevenness is formed by cutting the surface 21U, linear trances remain in cutting directions as shown in Fig. 25(b) and Fig. 25(c).

When unevenness is formed by using a foaming chemical, traces of circular foams remain as shown by reference numerals 111-1 to 111-7 in Fig. 22 or as shown in Fig. 25(d). The inner diameters of the recessed parts 111-1 to 111-7 may be constant or may vary. Like the recessed part 111-1, there may be a double circle shape where a protruded part 112-1 is formed in the recessed part 111-1. The protruded part 112-1 may be formed in the recessed parts 111-2 to 111-7. A circular shape included in unevenness may be formed not only in a recessed part, but also in a protruded part. The cross-sectional shapes of the unevenness shown in Fig. 22(a) and Fig. 22(b) are not limited to the shapes described above, but include arbitrary shapes formed when the unevenness is formed. For example, there can be a wedge shape, a hook shape, a trapezoidal shape, a pendular shape, a trapezoidal shape with two mountains, and the like.

Regarding the regularity of the unevenness, even when the regularity is not found in a small range, the regularity can be found in a large area. In particular, the electronic component mounting substrate is separated into chips and mounted on an electronic component, so that the regularity of the unevenness might not appear in a single chip depending on the forming method of the unevenness. In this case, a trace of unevenness forming substance may appear in two or more arbitrary numbers of chips.

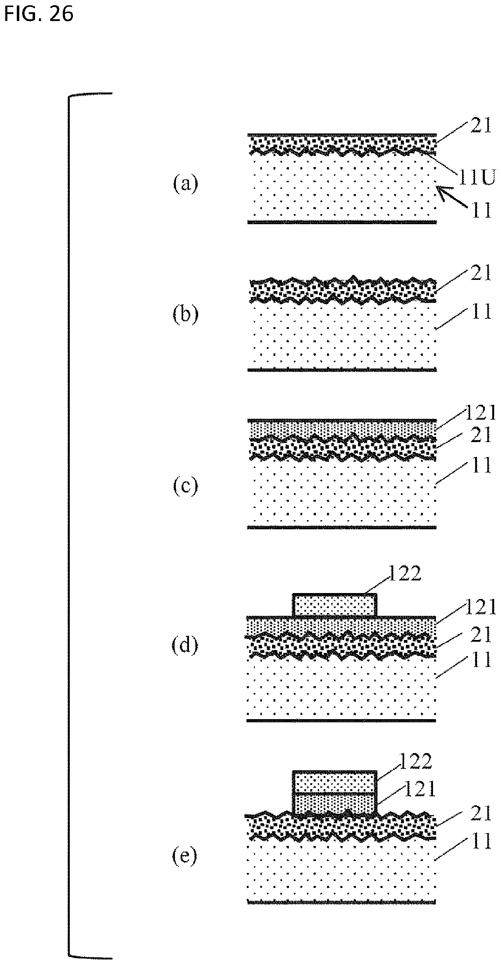

The method of manufacturing the electronic component mounting substrate according to the present disclosure will be described with reference to Fig. 26. The method of manufacturing the electronic component mounting substrate according to the present embodiment has an unevenness forming process between an adhesion layer forming process and a conductor forming process.

In the unevenness forming process, the adhesion layer 21 is formed on the insulating layer 11 (Fig. 26(a)), and unevenness is formed on the surface 21U of the adhesion layer 21 (Fig. 26(b)). The unevenness is formed in an entire area where a wiring pattern of the conductors 12 can be formed on the surface 21U. When the unevenness is formed in the entire surface 21U, the unevenness as shown in Fig. 21 is also formed in an area where the conductors 12 are not arranged on the surface 21U.

The forming method of the unevenness is optional. For example, uneven shapes formed on a plane or a roll are transferred to the surface 21U. Alternatively, a physical formation where an insulating sheet having uneven shapes is buried in the surface 21U, a mechanical formation where the surface 21U is cut by a brush or the like, and a chemical formation where the surface 21U is dissolved or swollen by using chemicals can be exemplified, and the above formations may be combined. The uneven shapes on the surface 21U of the adhesion layer 21 may be different between an area where the conductors 12 are arranged and the other area. When the adhesion layer 21 is formed on the insulating layer 11 (Fig. 26 (a)), unevenness may be formed on a surface 11U of the insulating layer 11. The forming method of the unevenness is the same as that of the uneven shapes on the surface 21U.

The conductor forming process is the same as that described in the first embodiment except that the electroless plating layer 121 is included in the present embodiment. The electroless plating layer 121 is formed (Fig. 26(c)), the electrolytic plating layer 122 is formed (Fig. 26(d)), and the electroless plating layer 121 is removed (Fig. 26(e)). As the formation of the electroless plating layer 121, in addition to chemical plating, coating of liquid or paste conductor can be exemplified. The formation of the electroless plating layer 121 is performed on the entire area where the wiring pattern of the conductors 12 can be formed on the surface 21U. The electrolytic plating layer 122 is formed into a shape of the wiring pattern. When the electroless plating layer 121 is removed, the electroless plating layer 121 formed in an area other than the wiring pattern is removed while the electrolytic plating layer 122 is left. At this time, corners (reference numeral 12E shown in Fig. 21) of the conductor 12 are rounded. In the present disclosure, the conductor 12 is grown from the insulating layer 11, so that corners of the upper surface of the conductor 12 opposite to the surface facing the insulating layer 11 are rounded in the cross section perpendicular to the insulating layer 11.

An area where the unevenness is formed and an area where the electroless plating layer 121 is formed on the surface 21U of the adhesion layer 21 may be only an area where the wiring pattern of the conductors 12 of the surface 21U is formed.

The electroless plating layer 121 may be directly formed into the shape of the wiring pattern without forming the electrolytic plating layer 122. In this case, the entire conductor 12 is formed by the electroless plating layer 121.

In the present embodiment, a single-sided substrate is exemplified as an example of the electronic component mounting substrate according to the present disclosure. However, the present disclosure is not limited to this. For example, the electronic component mounting substrate according to the present disclosure may be a double-sided substrate. In this case, the structure of the adhesion layer 21 and the conductor 12 described in the present embodiment may be formed on only one side or may be formed on both sides. The electronic component mounting substrate according to the present disclosure may be a multilayered substrate. In this case, the structure of the adhesion layer 21 and the conductor 12 described in the present embodiment may be included in at least one layer of the multilayered substrate.

As described above, in the present embodiment, the conductor 12 includes the electroless plating layer 21 in the lowermost layer facing the insulating layer 11, and the adhesion layer 21 and the electroless plating layer 21 are in contact with each other. Therefore, the present embodiment can provide an electronic component mounting substrate having high peel strength.

### (Fourth Embodiment)

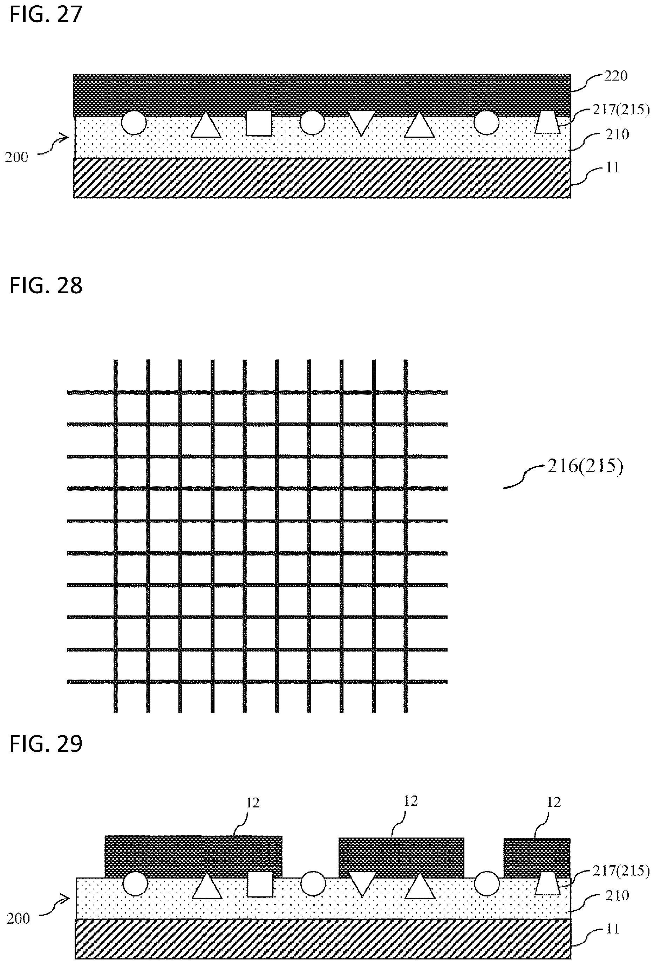

As shown in Fig. 27, a substrate such as an electronic component mounting substrate of the present embodiment may have the insulating layer 11, an adhesion layer 200 provided on the insulating layer 11, and a metal layer 220 provided on the adhesion layer 200. The adhesion layer 200 may have an adhesion main body layer 210 and anchor bodies 215 protruded from a front surface of the adhesion main body layer 210. The metal layer 220 may be patterned to be conductors 12 as shown in Fig. 29. The conductor 12 is one form of the metal layer 220 and is a concept included in the metal layer 220.

The anchor body 215 may be a mesh-like member 216 having a sheet shape as shown in Fig. 28 or may be a granular substance 217 as shown in Fig. 27.

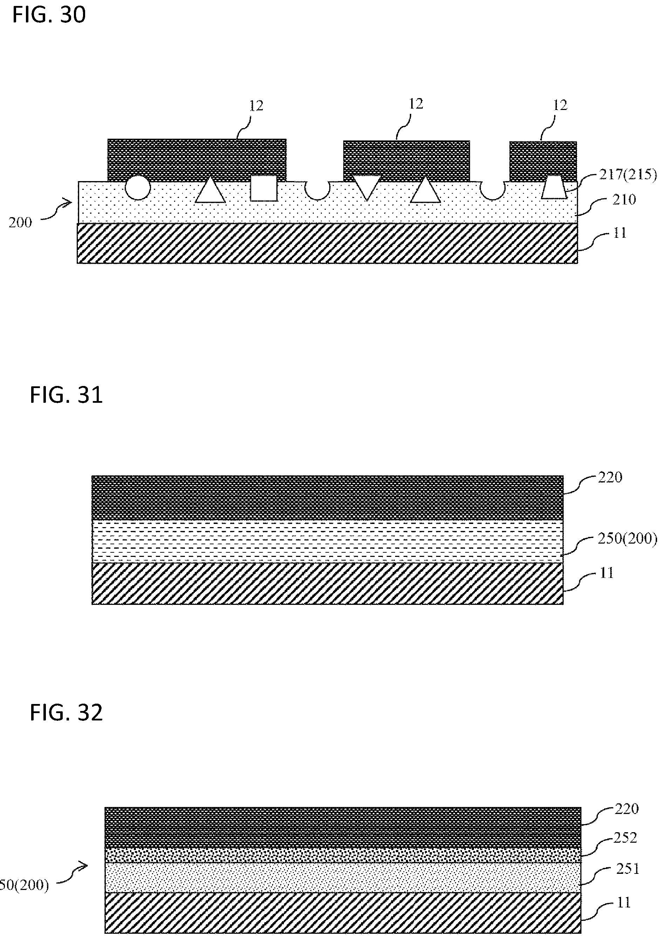

As shown in Fig. 29, when the metal layer 220 is patterned, the anchor bodies may remain without being removed. Not limited to this aspect, as shown in Fig. 30, when the metal layer 220 is patterned, the anchor bodies may be removed. When the anchor bodies are removed, recessed parts may be provided in the adhesion main body layer 210 in an area where the conductor 12 is not provided.

When the anchor body is the mesh-like member 216, parts of a bottom surface and side surfaces of the mesh-like member 216 may be buried in the adhesion main body layer 210, and a top surface of the mesh-like member 216 may be exposed from the adhesion main body layer 210.

When the anchor body is the granular substance 217, a part of the granular substance 217 may be buried in the adhesion main body layer 210, and a top surface of the granular substance 217 may be exposed from the adhesion main body layer 210.

The granular substance 217 may be a filler. The granular substance 217 may be a nitride, and for example, may be silicon nitride, aluminum nitride, or the like. When silicon nitride, aluminum nitride, or the like is employed, it is possible to improve heat dissipation effect.

The adhesion main body layer 210 may be a resist layer or an ink layer. The adhesion main body layer 210 contains the granular substance 217. A part of a front surface of the granular substance 217 may be exposed by removing the front surface of the adhesion main body layer 210 by etching or the like. According to this aspect, it is very beneficial that the granular substance 217 can be exposed by an easy manufacturing process.

Some of a plurality of granular substances 217 may have the largest area in a cross-section of the adhesion main body layer 210. In this case, the granular substance 217 is more strongly fixed into the adhesion main body layer 210, so that the metal layer 220 is pulled. Thereby, it is possible to more reliably prevent the granular substance 217 from being pulled out from the adhesion main body layer 210. As a result, a pillar strength can be further increased.

### (Fifth Embodiment)

As shown in Fig. 31, a substrate such as an electronic component mounting substrate of the present embodiment may have the insulating layer 11, an adhesion layer 200 provided on the insulating layer 11, and a metal layer 220 provided on the adhesion layer 200. The adhesion layer 200 may have a redox layer 250. The redox layer 250 is an oxidation layer that oxidizes the metal layer 220 or a reduction layer that reduces the metal layer 220. By providing the redox layer 250, the metal layer 220 and the redox layer 250 cause chemical reaction such as oxidation-reduction reaction, so that it is possible to adhere these layers together.

In a boundary of the redox layer 250 adjacent to the metal layer 220, a metal constituting the metal layer 220 and a metal oxide of the metal may coexist. When the metal layer 220 is copper, copper and copper oxide may coexist in the redox layer 250.

In a boundary of the redox layer 250 adjacent to the metal layer 220, a first material constituting the redox layer 250 and a reduced product of the first material may coexist. When the metal layer 220 is copper and becomes copper oxide, the redox layer 250 may be, for example, a carbon layer composed of carbon. In this case, the following reaction occurs between the metal layer 220 that becomes copper oxide and the redox layer 250 composed of carbon.

2CuO + C → 2Cu + CO₂

As shown in Fig. 32, the redox layer 250 may have a redox main body layer 251 and a boundary layer 252 provided on a side of the redox main body layer 251 facing the metal layer 220. In the boundary layer 252, the metal constituting the metal layer 220 and the metal oxide of the metal may coexist. In the boundary layer 252, the first material constituting the redox layer 250 and the reduced product of the first material may coexist.

The redox main body layer 251 may be provided directly on the insulating layer 11. A material constituting the redox main body layer has high adhesiveness with a material of the insulating layer 11. Therefore, by employing this aspect, it is possible to further increase adhesion strength between the insulating layer 11 and the metal layer 220.

In the same manner as in the other examples described above, the metal layer 220 may be patterned to be the conductors 12.

### (Sixth Embodiment)

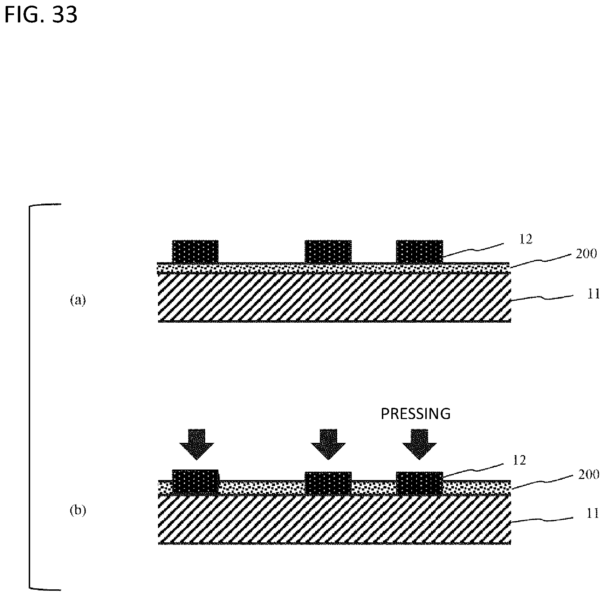

As shown in Fig. 33, the conductors 12 may be pushed in so as to penetrate the adhesion layer 200. In this case, the side surfaces of the conductor 12 are provided with the adhesion layer 200, and the bottom surface is not provided with the adhesion layer 200.

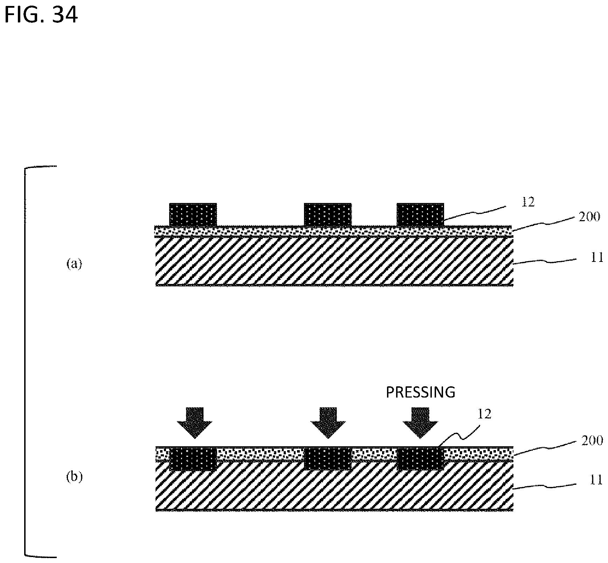

The insulating layer 11 is in a semi-cured state, so that as shown in Fig. 34, when the conductors 12 are pushed in so as to penetrate the adhesion layer 200, the conductors 12 may be pushed in the insulating layer 11. Also in this aspect, the side surfaces of the conductor 12 are provided with the adhesion layer 200, and the bottom surface is not provided with the adhesion layer 200.

### (Seventh Embodiment)

In the present embodiment, application examples of the electronic component mounting substrate according to the present disclosure will be described. An electronic component according to the present embodiment includes the electronic component mounting substrate according to the present disclosure and performs predetermined processing by using the electronic component mounting substrate according to the present disclosure. The processing is arbitrary processing performed by the electronic component.

In an electronic device according to the present embodiment, an electronic component according to the present disclosure is used in at least one of mounted electronic components. In a mounting apparatus according to the present embodiment, an electronic component or an electronic device according to the present disclosure is used in at least one of mounted electronic components and electronic devices.

The present disclosure can be applied to various apparatuses including the electronic component mounting substrate. Examples of the apparatus to which the present disclosure can be applied include a vehicle, an electrical home appliance, a communication device, a control instrument, a sensor, a robot, a drone, an airplane, a spaceship, a ship, a production machine, a construction machine, a testing machine, a surveying machine, a computer related product, a digital device, a game machine, and a clock.

Each apparatus is equipped with an arbitrary function suitable to the apparatus. The electronic component mounting substrate according to the present disclosure is used for an electronic device such as an electronic chip used when the function is performed. The electronic component mounting substrate according to the present disclosure can improve the peel strength, so that it is possible to improve reliability of an electronic component, an electronic device, and an apparatus.

### Industrial Applicability

The electronic component mounting substrate of the present disclosure and the manufacturing method thereof can be mounted on various electronic apparatuses and applied to manufacturing of electronic apparatus.

### Reference Signs List

11 insulating layer
111-1, 111-2, 111-3, 111-4, 111-5, 111-6, 111-7 recessed part
112-1, 112-6, 112-9 protruded part
113 tunnel
12, 12-1, 12-2, 12-3 conductor
121 electroless plating layer
122 electrolytic plating layer
13 pattern resist
14, 14-1, 14-2, 14-3 insulating layer
15 VIA
21 adhesion layer partially or wholly composed of an insulating material
22 second adhesion layer partially or wholly composed of an insulating material

## Claims

1. A substrate comprising:
an insulating layer;
an adhesion layer provided on the insulating layer; and
a metal layer provided on the adhesion layer, wherein
the adhesion layer has an adhesion main body layer and an anchor body protruded from a front surface of the adhesion main body layer or has a redox layer.

2. The substrate according to claim 1, wherein
the adhesion layer has the redox layer, and
in a boundary of the redox layer adjacent to the metal layer, a metal constituting the metal layer and a metal oxide of the metal coexist.

3. The substrate according to claim 1 or 2, wherein
the adhesion layer has the redox layer, and
in a boundary of the redox layer adjacent to the metal layer, a first material constituting the redox layer and a reduced product of the first material coexist.

4. The substrate according to any one of claims 1 to 3, wherein
the adhesion layer has the redox layer,
the redox layer has a redox main body layer and a boundary layer provided on a metal layer side of the redox main body layer, and
in the boundary layer, a metal constituting the metal layer and a metal oxide of the metal coexist, or a first material constituting the redox layer and a reduced product of the first material coexist.

5. The substrate according to claim 4, wherein
the redox main body layer is provided directly on the insulating layer.

6. The substrate according to claim 1, wherein
the adhesion layer has an adhesion main body layer and an anchor body protruded from a front surface of the adhesion main body layer,
the anchor body is a granular substance, and
a part of the granular substance is buried in the adhesion main body layer.

7. The substrate according to claim 6, wherein
the granular substance is a nitride.

8. The substrate according to claim 6 or 7, wherein
the adhesion main body layer is a resist layer or an ink layer.

9. The substrate according to any one of claims 6 to 8, wherein
one or more granular substances have largest area in a cross-section of the adhesion main body layer.

10. The substrate according to any one of claims 1 to 9, wherein
the metal layer is a patterned conductor, and
a bottom surface and at least a part of a side surface of the conductor are located on a back surface side of the adhesion layer than a front surface of the adhesion layer.

11. The substrate according to claim 10, wherein
the adhesion layer is provided on the side surface and the bottom surface of the conductor.

12. The substrate according to claim 10, wherein
the adhesion layer is provided on the side surface of the conductor and the adhesion layer is not provided on the bottom surface of the conductor.

13. The substrate according to any one of claims 1 to 12, wherein
the insulating layer has a plurality of laminated insulating layers which are laminated,
the adhesion layer has a plurality of laminated adhesion layers which are laminated,
the laminated adhesion layer is provided on the laminated insulating layer, and
the metal layer is provided on the laminated adhesion layer.

14. An electronic apparatus comprising:
the substrate according to any one of claims 1 to 13; and
an electronic component provided on the substrate, wherein
the electronic component is provided on the conductor.

15. Amounting apparatus comprising the electronic apparatus according to claim 14.
